# EUROPEAN PATENT APPLICATION

(11) **EP 4 333 565 A1**
(43) Date of publication of application: **06.03.2024**
(21) Application number: 22193470.6
(22) Date of filing: 01.09.2022
(51) Int. Cl.: H05K 1/02, H05K 1/11, H01L 23/498, H05K 3/34, H05K 3/40, H01L 23/31, H01L 23/538, H01L 25/065

(54) **ELECTRONIC COMPONENT WITH REDUCED STRESS**

(71) Applicant: Murata Manufacturing Co., Ltd., Nagaokakyo-shi, Kyoto 617-8555 (JP)
(72) Inventor: ENDO, Shigeru, Yokohama (JP); NURMI, Sami, Tuusula (FI)
(74) Representative: Boco IP Oy Ab

(57) **Abstract**

This disclosure describes a packaging arrangement that allows the suppression of the stress induced by extreme temperature changes during the process of attaching the electronic component. The result is achieved by adding to the package columnar conductors embedded in a solid support substance.

## Description

### FIELD OF THE DISCLOSURE

This disclosure relates to electronic components, and particularly packaging electronic components with solid support substance. The present disclosure further concerns the reduction of stress in such components.

### BACKGROUND OF THE DISCLOSURE

Electronic chips, which may also be called dies, are usually prepared by manufacturing various electronic structures on a substrate and cutting the substrate into small, chip-size pieces. These dies may be microelectromechanical systems (MEMS) electronic devices formed from a silicon wafer by etching and coating techniques. Each chip can then be placed inside a protective package which forms an enclosure where the chip is protected from the surrounding environment. The chip can be mechanically attached to a support structure inside the enclosure, such as a die pad, and electrically connected to contacts which extend outside of the enclosure. The packaged chip thereby forms an electronic component which can be mounted on a printed circuit board (PCB). Standard PCBs such as FR-1, FR-2, FR-3, FR-4, or LTCC PCBs can be used.

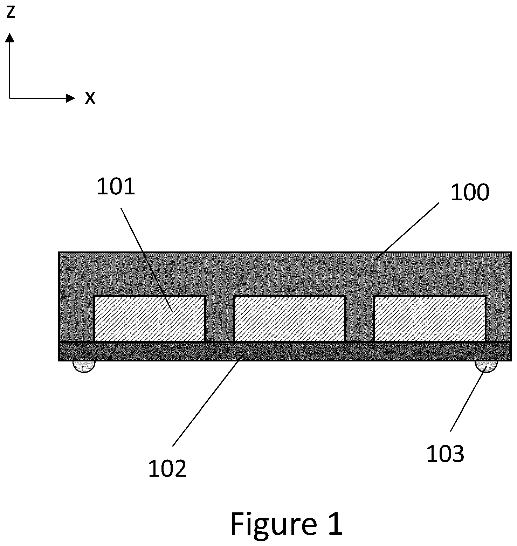

Electronic components typically comprise at least one electronic chip and a package. The package frame can be made of a molded hollow plastic box or epoxy resin in which electronic devices are embedded. Figure 1 illustrates schematically an electronic component known from the prior art. The chips 101 are mounted on an internal printed circuit board 102 inside the component package 100 and may be electrically connected to an external printed circuit board via soldering bumps 103 which extend out of the package. During the soldering process, metal solder is heated at temperatures beyond its melting point, typically above 200°C, then cooled down to much lower temperatures which can reach -40°C. Many electronic chips, especially MEMS, are sensitive to extreme changes in temperatures, so one objective of component designs is to reduce the stress that is induced by temperature variations during the soldering process.

### BRIEF DESCRIPTION OF THE DISCLOSURE

An object of the present disclosure is to provide a solution to the problem described above. The disclosed solution permits to reduce the stress induced by extreme temperature changes during the soldering process and application field conditions.

The object of the disclosure is achieved by an arrangement which is characterized by what is stated in the independent claims. The preferred embodiments of the disclosure are disclosed in the dependent claims.

The disclosure is based on the idea of including to the structure columnar conductors which are embedded in a solid support substance. An advantage of the disclosure is that when the solder bumps are deposited, the solid support substance decreases temperature related deformations of the columnar conductors and the printed circuit board, reducing thereby strain inside the electronic devices. This provides new improvements in device reliability.

### BRIEF DESCRIPTION OF THE DRAWINGS

In the following, the disclosure will be described in greater detail by means of preferred embodiments with reference to the accompanying drawings, in which
Figure 1 illustrates an electronic component known from the prior art;
Figures 2a - 2c illustrate an electronic component comprising one die connected to a circuit board and columnar conductors embedded in a solid support substance;
Figures 3a - 3c illustrate a bottom view of the circuit board where two distinct sections are defined. A peripheral section, which is adjacent to the edges of the circuit board, and a central section;
Figures 4a - 4c illustrate electronic components comprising a printed circuit board, an ASIC device, MEMS devices, columnar conductors embedded in a solid support substance, and solder bumps;
Figure 5 illustrates possible configurations for organizing the columnar conductors in the electronic component wherein the columnar conductors are evenly distributed within the peripheral section of the circuit board;
Figures 6a - 6c illustrate possible configurations for organizing the columnar conductors in the electronic component wherein the columnar conductors are evenly distributed within the peripheral and central sections of the printed circuit board;
Figures 7a - 7c illustrate electronic components comprising a printed circuit board, an ASIC device, MEMS devices, columnar conductors, additional electronic devices attached to the bottom side of the printed circuit board, and solder bumps. All the electronic devices are embedded in the solid support substance;
Figure 8 illustrates possible configurations for organizing the columnar conductors in the electronic compound, wherein the columnar conductors are evenly distributed within the peripheral section of the circuit board and additional electronic devices are attached to the bottom side of the printed circuit board;
Figures 9a - 9b illustrate possible configurations for organizing the columnar conductors in the electronic compound, wherein the columnar conductors are evenly distributed within the peripheral and central sections of the circuit board and additional electronic devices are attached to the bottom side of the printed circuit board;

### DETAILED DESCRIPTION OF THE DISCLOSURE

The disclosure describes an electronic component comprising a circuit board with a top side and a bottom side, wherein the circuit board defines a horizontal xy-plane and a vertical z-direction which is perpendicular to the xy-plane. The circuit board has a circuit board area in the xy-plane. The electronic component further comprises one or more dies attached to the top side of the circuit board and a package with a top half and a bottom half. The top half of the package is attached to the top side of the circuit board and surrounds the one or more dies, and the bottom half of the package is attached to the bottom side of the circuit board so that the bottom surface of the bottom half of the package forms the bottom of the component.

The electronic component further comprises vertical columnar conductors which extend from the bottom side of the circuit board through the bottom half of the package. The bottom half of the package comprises a solid support substance in which the columnar conductors are embedded. The total columnar conductors' area within the circuit board is greater than 4 % of the printed circuit board area. This applies to all embodiments of this disclosure.

The expressions "top of the component" and "bottom of the component" refer here only to how the component is intended to be mounted, for example onto an external circuit board. The bottom side of the component is intended to be attached to the surface of the external circuit board. That external circuit board could be oriented in any manner. The expressions "top half of the package" and "bottom half of the package" relate to how the two parts of the package are intended to be built. The bottom half of the package is the half surrounding the columnar conductors. The expressions "top side of the circuit board" and "bottom side of the circuit board" refer to how the internal circuit board is placed inside the package. The bottom side of the internal circuit board is the side to which the columnar conductors are connected. Words such as "bottom" and "top", "above" and "below" do not refer to the orientation of the component with regard to the direction of earth's gravitational field either when the component is manufactured or when it is in use. The plane defined by the x- and y-axes is parallel to the plane of the printed circuit board to which the dies are attached. The direction defined by the z-axis is perpendicular to the same circuit board plane. The columnar conductors may be metal pins which may be prepared by plating. They have a length and a surface area. The columnar conductors' area refers here to the surface that is touching the circuit board. The pins' area or the columnar conductors' area within a specific section refers to the sum of all columnar conductors' areas within that specific section of the printed circuit board. The total columnar conductors' area within the circuit board is defined by the sum of all columnar conductors' areas. The number of columnar conductors within the circuit board may be greater than 3, 6, 10, 20, 30, 40, 50, 60, 70, 80, 90, or 100. The columnar conductors' number density refers to the number of columnar conductors per unit of surface in the xy-plane. Solid support substance refers here to any substance that is included into a volume of the electronic component so that it fits contours of elements embedded into it in that volume. The solid support substance can be provided as a pre-cast solid element with hollows that match with forms of the embedded elements, or it can be cast on the embedded elements in a manufacturing stage of the electronic component. Examples of the solid support substance may include low conductivity or insulating materials such as mold compounds, polymers, plastics, ceramics, or resins.

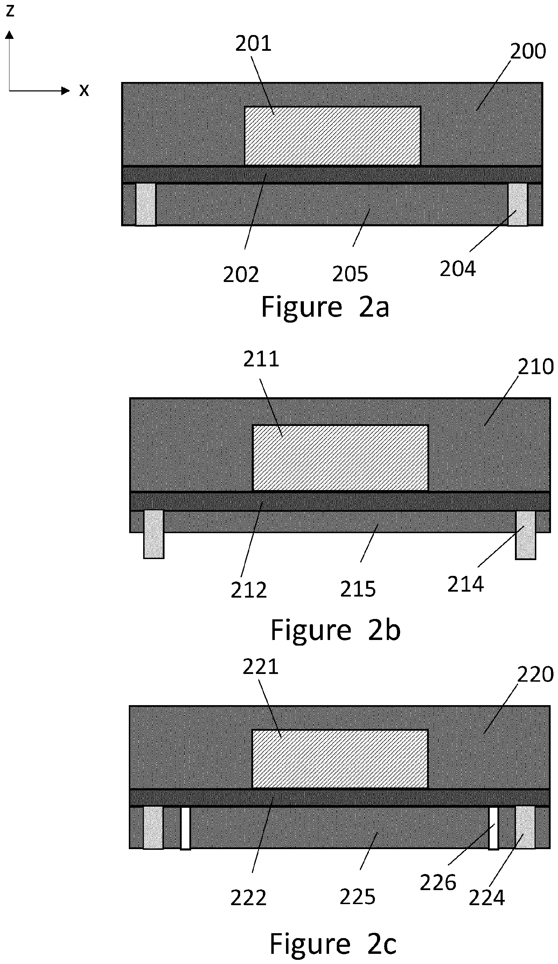

Figures 2a - 2c illustrate schematically examples of such component. Figure 2a illustrates an example showing an electronic component which comprises one die 201, such as a MEMS or ASIC chip, connected to a circuit board 202 and columnar conductors 204 embedded in a solid support substance which forms the bottom half 205 of the package. The component may comprise more dies which may either be similar or different. The top half of the package 200 which may either be a hollow plastic frame or a solid support substance, such as a mold compound, is molded onto the printed circuit board so that the chips are enclosed inside the package walls. The full electronic component which comprises the package, the dies and the printed circuit board may be electrically connected to an external circuit board via solder bumps. The inclusion of the columnar conductors in the bottom half of the package, which is formed by the solid support substance around the columnar conductors, suppresses temperature induced deformations. The columnar conductors may be substantially evenly distributed in the circuit board area. They may be distributed adjacently to the edges of the circuit board and/or in the center of the circuit board. They may be randomly or symmetrically arranged. They may be made of an electrically conductive metal such as copper, silver, gold, aluminium. The columnar conductors may either be used as electrical contacts or as dummies. The latter have no electric function and only contribute to stress suppression. The options presented in this paragraph apply to all embodiments presented in this disclosure.

Figure 2b illustrates an example showing an electronic component which comprises one die 211, such as a MEMS or ASIC chip, connected to a circuit board 212 and columnar conductors 214 embedded in a solid support substance which forms the bottom half 215 of the package. The thickness of the solid support substance in the z-direction may be shorter than the length of the columnar conductors 214 in the z-direction. The component may comprise more dies which may either be similar or different. The top half of the package 210 which may either be a hollow plastic frame or a solid support substance, such as a mold compound, is molded onto the printed circuit board so that the chips are enclosed inside the package walls. The full electronic component which comprises the package, the dies and the printed circuit board may be electrically connected to an external circuit board via solder bumps. In figure 2b, reference numbers 210, 211, 212, 214 and 215 correspond to reference numbers 200, 201, 202, 204 and 205 respectively in figure 2a.

Figure 2c illustrates an example showing an electronic component which comprises one die 221, such as a MEMS or ASIC chip, connected to a circuit board 222 and columnar conductors 224 embedded in a solid support substance which forms the bottom half 225 of the package. The solid support substance may comprise trenches 226. The trenches 226 may extend from the bottom side of the circuit board to the bottom of the solid substance. The trenches are long narrow channels which may be drawn anywhere in the xy-plane and may surround either a single or several columnar conductors 224. One or more trenches may be prepared across or within the solid support substance to separate two or more regions of the solid support substance from each other. The electronic component may comprise more dies which may either be similar or different. The top half of the package 220 which may either be a hollow plastic frame or a solid support substance, such as a mold compound, is molded onto the printed circuit board so that the chips are enclosed inside the package walls. The full electronic component which comprises the package, the dies and the printed circuit board may be electrically connected to an external circuit board via solder bumps. In figure 2c, reference numbers 220, 221, 222, 224 and 225 correspond to reference numbers 200, 201, 202, 204 and 205 respectively in figure 2a.

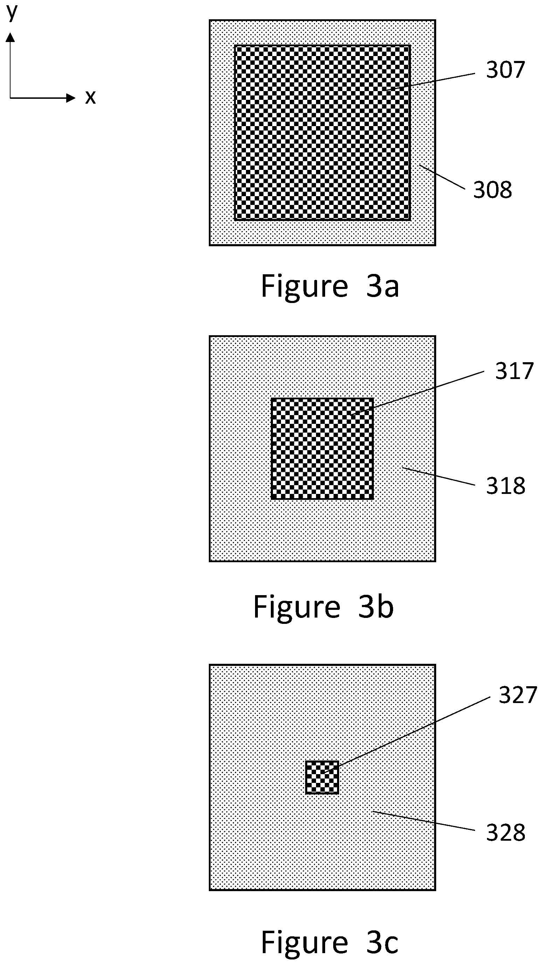

Figures 3a - 3c illustrate examples of how a circuit board area can be divided into two different sections: a central section and a peripheral section. The peripheral section is defined as being directly adjacent to the edges of the circuit board and surrounding the central section. Figure 3a illustrates an example showing a circuit board in which the central section 307 covers 60% and the peripheral section 308 covers 40% of the full board area. Figure 3b illustrates an example showing a circuit board in which the central section 317 covers 20% and the peripheral section 318 covers 80% of the full board area. Figure 3c illustrates an example showing a circuit board in which the central section 327 covers 2% and the peripheral section 328 covers 98% of the full board area. Optionally, the columnar conductors in the central section may be substantially evenly distributed within the central section, and the columnar conductors in the peripheral section may be substantially evenly distributed within the peripheral section.

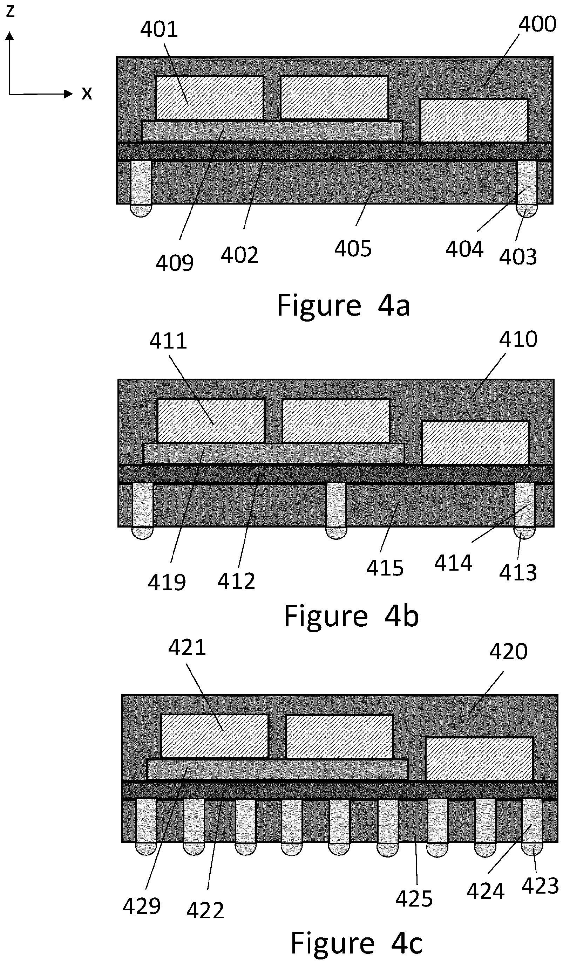

Figure 4a illustrates a side view of an electronic component which comprises an internal printed circuit board 402 to which several dies 401 and 409, such as MEMS and/or ASIC dies, are electrically connected. The dies 401 and 409 may be embedded in a solid support substance which forms the top half 400 of the package. The component further comprises columnar conductors 404 which are embedded in the solid support substance that forms the bottom half 405 of the package. The columnar conductors 404 are evenly distributed within the peripheral section of the printed circuit board 402. The columnar conductors 404 are connected to the solder bumps 403 that may be attached to an external circuit board. In figure 4a, reference numbers 400, 401, 402, 404 and 405 correspond to reference numbers 200, 201, 202, 204 and 205 respectively in figure 2a.

Figure 4b illustrates a side view of an electronic component which comprises an internal printed circuit board 412 to which several dies 411 and 419, such as MEMS and/or ASIC dies, are electrically connected. The dies 411 and 419 may be embedded in a solid support substance which forms the top half 410 of the package. The component further comprises columnar conductors 414 which are embedded in the solid support substance that forms the bottom half 415 of the package. The columnar conductors 414 are evenly distributed within the central and peripheral sections of the printed circuit board 412. The columnar conductors 414 are connected to the solder bumps 413 that may be attached to an external circuit board. Many other columnar conductors' distribution geometries are also possible. In figure 4b, reference numbers 410, 411, 412, 413, 414, 415 and 419 correspond to reference numbers 400, 401, 402, 403, 404, 405 and 409 respectively in figure 4a.

Figure 4c illustrates a side view of an electronic component with a large columnar conductors' number density. The electronic component comprises an internal printed circuit board 422 to which several dies 421 and 429, such as MEMS and/or ASIC dies, are electrically connected. The dies 421 and 429 may be embedded in a solid support substance which forms the top half 420 of the package. The component further comprises columnar conductors 424 which are embedded in the solid support substance that forms the bottom half of the package 425. The columnar conductors 424 are evenly distributed within the central and peripheral sections of the printed circuit board 422. The columnar conductors 424 are connected to the solder pumps 423 that may be attached to an external circuit board. Many other columnar conductors' distribution geometries are also possible. In figure 4c, reference numbers 420, 421, 422, 423, 424, 425 and 429 correspond to reference numbers 400, 401, 402, 403, 404, 405 and 409 respectively in figure 4a.

The circuit board area may consist of a central section which covers 30 - 70% or 40 - 60% of the circuit board area and a peripheral section which covers the rest of the circuit board area. The peripheral section surrounds the central section.

The columnar conductors' area within the central section may be less than the columnar conductors' area in the peripheral section. There may be no columnar conductors in the central section. All columnar conductors are then in the peripheral section. Alternatively, the columnar conductors' area within the central section may be less than 4%, 10%, 20%, 30%, 40%, or 50% of the area of the central section, and the columnar conductors' area within the peripheral section may be greater than 4%, 10%, 20%, 30%, 40%, or 50% of the area of the peripheral section.

The columnar conductors' area within the peripheral section may be less than the columnar conductors' area in the central section. There may be no columnar conductors in the peripheral section. Alternatively, the columnar conductors' area within the peripheral section may be less than 4%, 10%, 20%, 30%, 40%, or 50% of the area of the peripheral section, and the columnar conductors' area within the central section may be greater than 4%, 10%, 20%, 30%, 40%, 50%, 60%, 70%, 80%, 90% or close to 100% of the area of the central section.

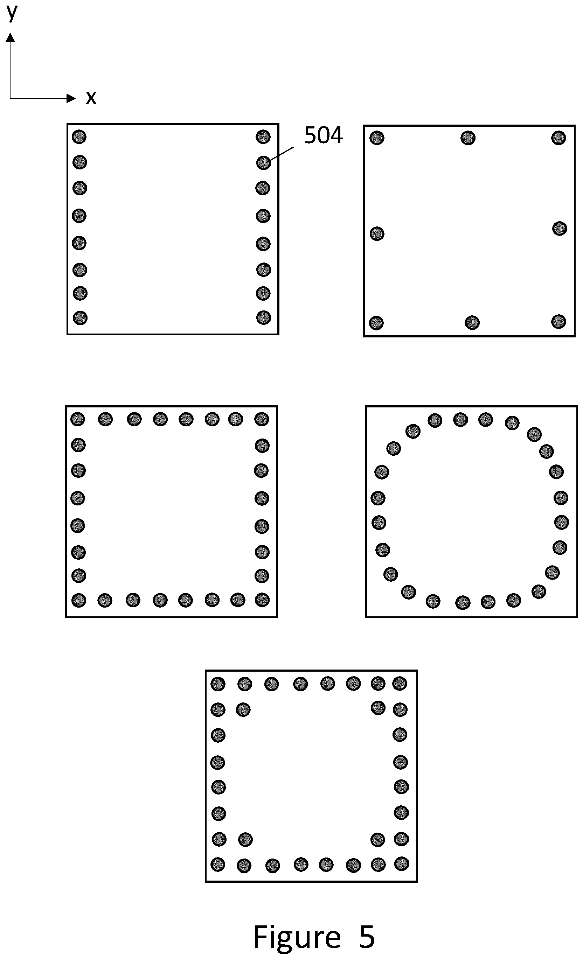

Figure 5 illustrates a bottom view of electronic components with columnar conductors 504 evenly distributed exclusively in the peripheral section of the printed circuit boards. reference number 504 in figure 5 corresponds to reference number 404 in figure 4a. Different examples of columnar conductors' arrangement geometries, such as straight line, square and circle, are shown.

The options presented above with regard to the central section and peripheral section apply to all embodiments presented in this disclosure.

The columnar conductors may be distributed substantially symmetrically with respect to the center of the circuit board area. The smallest horizontal distance between two adjacent columnar conductors may be greater than 0.3 mm, or 0.5 mm or 1 mm whereas the greatest horizontal distance between two adjacent columnar conductors may be less than 10 mm, or 5 mm or 3 mm. This option can be combined with any of the columnar conductors' area options and arrangement geometries in this disclosure.

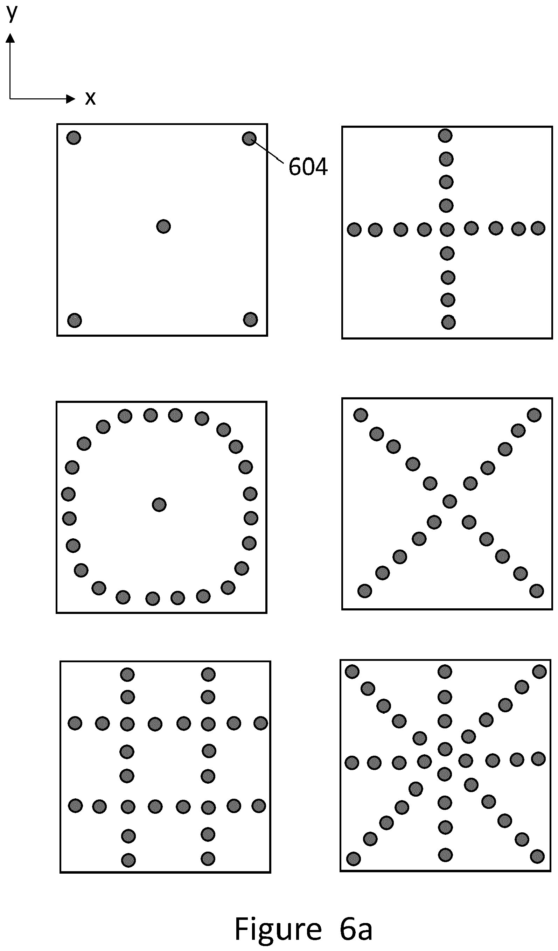

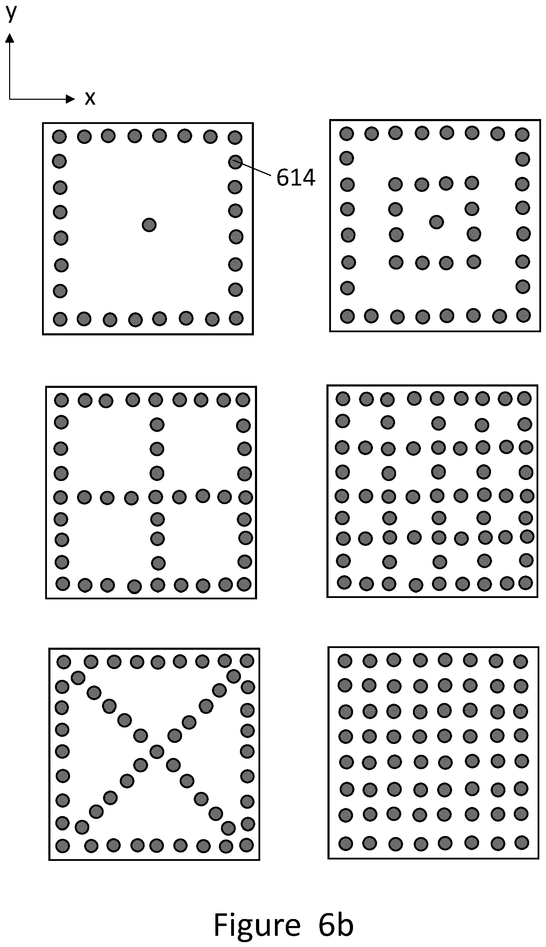

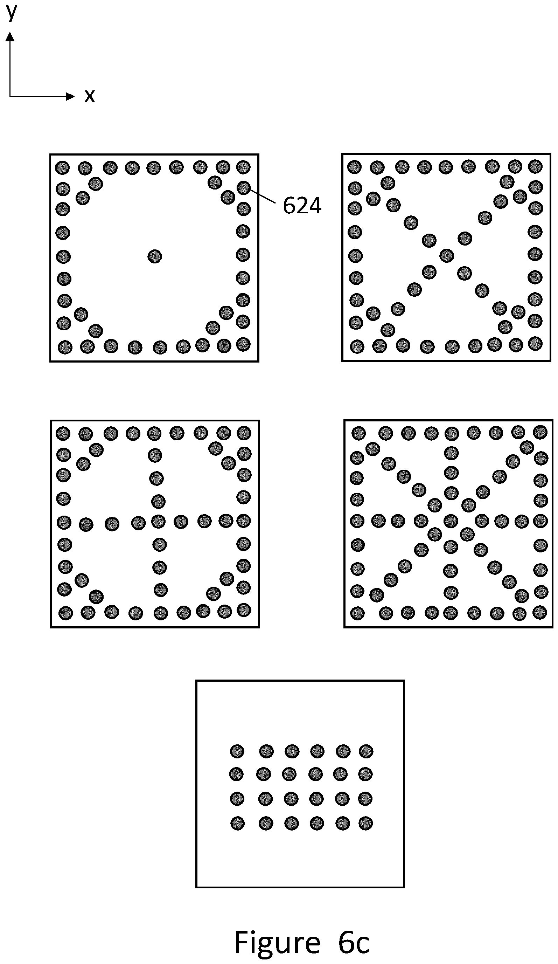

Figures 6a - 6c illustrate a bottom view of electronic components with columnar conductors 604, 614, 624 evenly distributed in the peripheral and central sections of the printed circuit boards. Different examples of columnar conductors' arrangement geometries, such as middle-square, cross, middle-circle, X, rectangle, and combinations of those arrangements, such as X-cross, square-cross, square-X, circle-cross, circle-X and square-cross-X, are shown. For example, the bottom image on figure 6c shows an embodiment in which the columnar conductors form a rectangle. The columnar conductors in this embodiment are distributed within the central section and a portion of the peripheral section which surrounds the center of the circuit board. In this embodiment no columnar conductors are connected near the edges of the circuit board. Reference number 604 in figure 6a corresponds to reference number 504 in figure 5. Reference number 614 in figure 6b corresponds to reference number 604 in figure 6a. Reference number 624 in figure 6c corresponds to reference number 604 in figure 6a.

The electronic component may also comprise one or more additional dies attached to the bottom side of the circuit board. The additional dies are also embedded in the solid support substance. These may be active devices such as MEMS dies and/or ASIC dies and/or microcontroller units, or passive devices such as capacitors, inductors, resistors, transformers, diodes. The additional devices which are connected to the bottom side of the printed circuit board might also contribute to stress suppression. In one possible embodiment, the one or more dies may for example comprise a MEMS die and the one or more additional dies may comprise an ASIC die. In another possible embodiment, the one or more dies may comprise a MEMS die and the one or more additional dies may comprise a microcontroller unit die.

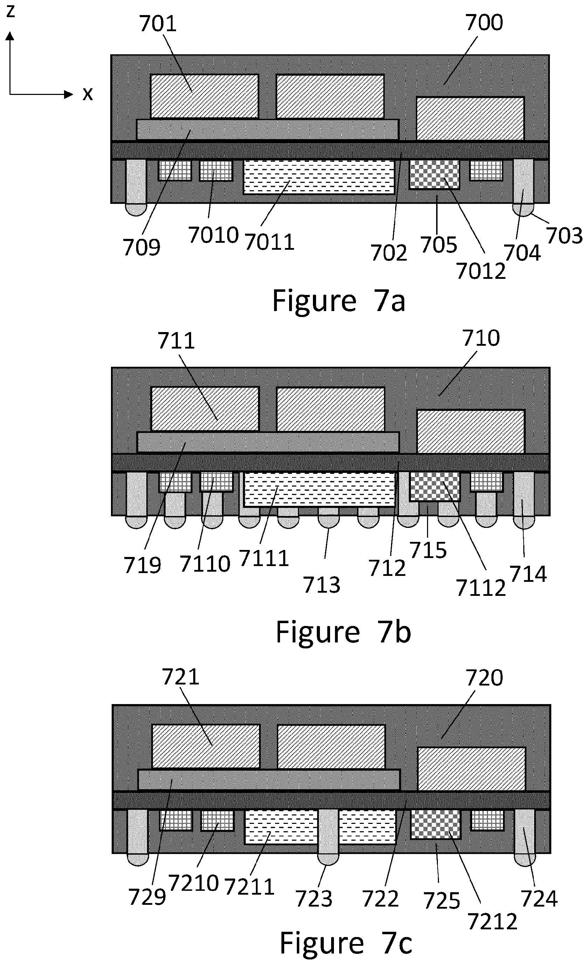

Figure 7a illustrates a side view of an electronic component which comprises an internal printed circuit board 702 to which dies 701 and 709, such as MEMS and ASIC dies, are electrically connected. The dies 701 and 709 are embedded in a solid support substance which forms the top half of the package 700. The component further comprises additional dies 7010, 7011 and 7012 and columnar conductors 704 which are embedded in the solid support substance that forms the bottom half of the package 705. For example, the additional dies may be passive parts and/or a microcontroller unit. The columnar conductors 704 are evenly distributed within the peripheral section of the printed circuit board 702. The columnar conductors 704 are connected to the solder pumps 703 that may be attached to an external circuit board. In figure 7a, reference numbers 700, 701, 702, 703, 704, 705 and 709 correspond to reference numbers 400, 401, 402, 403, 404, 405 and 409 respectively in figure 4a.

Figure 7b illustrates a side view of an electronic component which comprises an internal printed circuit board 712 to which dies 711 and 719, such as MEMS and ASIC dies, are electrically connected. The dies 711 and 719 are embedded in a solid support substance which forms the top half of the package 710. The component further comprises additional dies 7110, 7111 and 7112 and a large number density of columnar conductors 714 which are embedded in the solid support substance that forms the bottom half of the package 715. For example, the additional dies may be passive parts and/or a microcontroller unit. The columnar conductors 714 are evenly distributed within the peripheral section of the printed circuit board 712. The columnar conductors 714 are connected to the solder pumps 713 that may be attached to an external circuit board. In figure 7b, reference numbers 710, 711, 712, 713, 714, 715, 719, 7110, 7111 and 7112 correspond to reference numbers 700, 701, 702, 703, 704, 705, 709, 7010, 7011 and 7012 respectively in figure 7a.

Figure 7c illustrates a side view of an electronic component which comprises an internal printed circuit board 722 to which dies 721 and 729, such as MEMS and ASIC dies, are electrically connected. The dies 721 and 729 are embedded in a solid support substance which forms the top half of the package 720. The component further comprises additional dies 7210, 7211 and 7212 and columnar conductors 724 which are embedded in solid support substance that forms the bottom half of the package 725. For example, the additional dies may be passive parts and/or a microcontroller unit. The columnar conductors 724 are evenly distributed within the peripheral and central sections of the printed circuit board 722. The columnar conductors 724 are connected to the solder pumps 723 that may be attached to an external circuit board. In figure 7c, reference numbers 720, 721, 722, 723, 724, 725, 729, 7210, 7211 and 7212 correspond to reference numbers 710, 711, 712, 713, 714, 715, 719, 7110, 7111 and 7112 respectively in figure 7b.

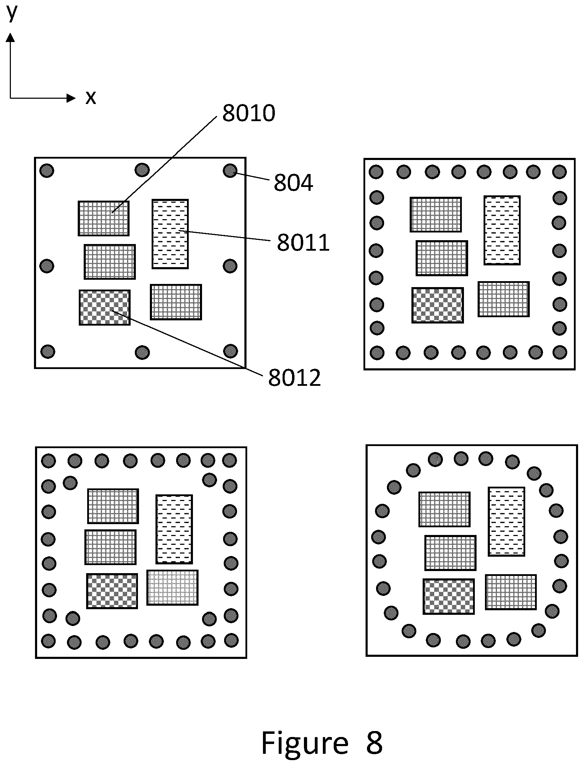

Figure 8 illustrates a bottom view of electronic components with columnar conductors 804 evenly distributed in the peripheral section of the printed circuit boards. The components further comprise additional dies 8010, 8011 and 8012 which are also embedded in the solid support substance that forms the bottom half of the package. The additional dies may for example be passive parts and/or a microcontroller unit. Different possible geometries of columnar conductors' distributions, such as square and circle shapes, are shown. In figure 8, reference numbers 804, 8010, 8011 and 8012 correspond to reference numbers 704, 7010, 7011 and 7012 respectively in figure 7a.

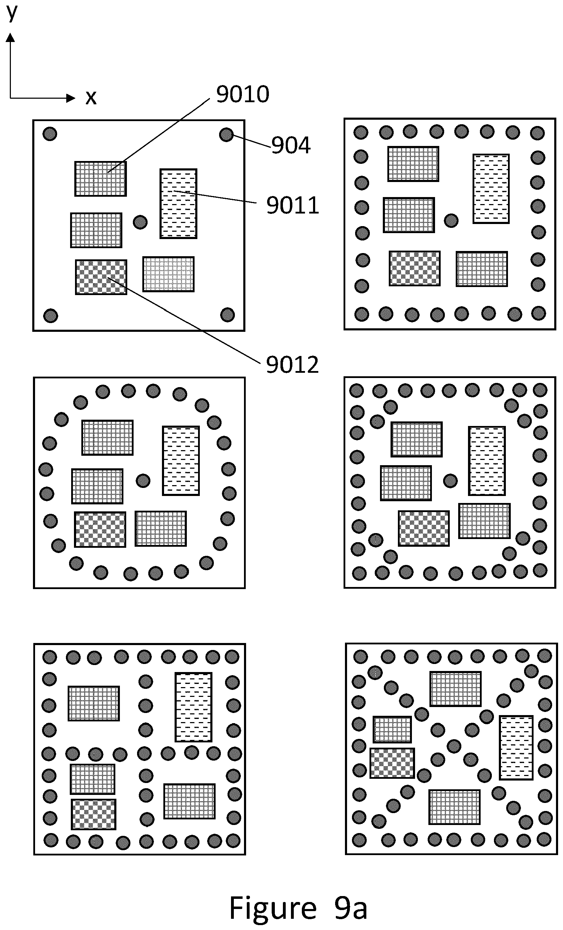

Figure 9a illustrates a bottom view of electronic components with columnar conductors 904 evenly distributed in the peripheral and central sections of the printed circuit boards. The components further comprise passive parts 9010 and 9012 and, for example a microcontroller unit 9011 which are embedded in the solid support substance that forms the bottom half of the package. Different possible geometries of columnar conductors' distributions, such as middle-square, middle-circle, square-cross and square-X, are shown. In figure 9a, reference numbers 904, 9010, 9011 and 9012 correspond to reference numbers 804, 8010, 8011 and 8012 respectively in figure 8.

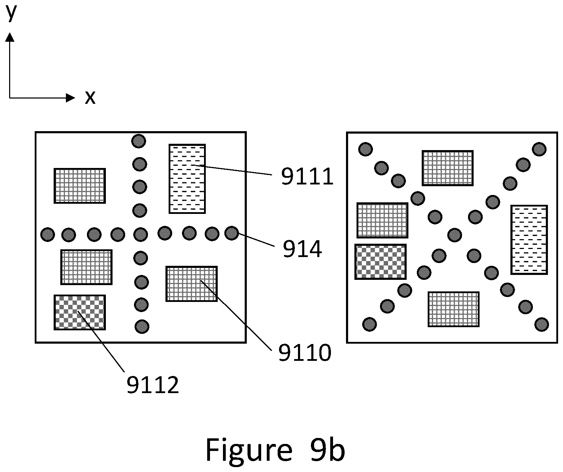

Figure 9b illustrates a bottom view of electronic components with columnar conductors 914 evenly distributed in the peripheral and central area of the printed circuit boards. The number of the columnar conductors in the central section is larger than the number of the columnar conductors in the peripheral section. The components comprise passive parts 9110 and 9112 and, a microcontroller unit 9111 which are embedded in the solid support substance that forms the bottom half of the package. Columnar conductors' distribution geometries such as cross and X are shown. In figure 9b, reference numbers 914, 9110, 9111 and 9112 correspond to reference numbers 904, 9010, 9011 and 9012 respectively in figure 9a.

## Claims

1. An electronic component comprising:
- a circuit board with a top side and a bottom side, wherein the circuit board defines a horizontal xy-plane and a vertical z-direction which is perpendicular to the xy-plane, and the circuit board has a circuit board area in the xy-plane,
- one or more dies attached to the top side of the circuit board,
- a package with a top half and a bottom half,
wherein the top half of the package is attached to the top side of the circuit board and surrounds the one or more dies, and the bottom half of the package is attached to the bottom side of the circuit board so that the bottom surface of the bottom half of the package forms the bottom of the component,
**characterized in that**
the electronic component further comprises vertical columnar conductors which extend from the bottom side of the circuit board through the bottom half of the package, and the bottom half of the package comprises a solid support substance, and the columnar conductors are embedded in the solid support substance, and the total columnar conductors' area within the circuit board is greater than 4% of the printed circuit board area.

2. An electronic component according to claim 1, wherein the columnar conductors are substantially evenly distributed in the circuit board area.

3. An electronic component according to any of claims 1-2, wherein the solid support substance comprises trenches, and the trenches extend from the bottom side of the circuit board to the bottom of the solid support substance.

4. An electronic component according to any of claims 1-3, wherein the circuit board area consists of a central section and a peripheral section which surrounds the central section, and the columnar conductors' area within the central section is less than the columnar conductors' area within the peripheral section.

5. An electronic component according to any of claims 1-3, wherein the circuit board area consists of a central section and a peripheral section which surrounds the central section, and the columnar conductors' area within the central section is greater than the columnar conductors' area within the peripheral section.

6. An electronic component according to any of claim 4-5, wherein the columnar conductors in the central section are substantially evenly distributed within the central section, and the columnar conductors in the peripheral section are substantially evenly distributed within the peripheral section.

7. An electronic component according to any preceding claim, wherein the smallest horizontal distance between two adjacent columnar conductors is greater than 0.3 mm.

8. An electronic component according to any preceding claim, wherein the greatest horizontal distance between two adjacent columnar conductors is less than 10 mm.

9. An electronic component according to any preceding claim, wherein the columnar conductors are distributed substantially symmetrically with respect to the center of the circuit board area.

10. An electronic component according to any preceding claim, wherein the component also comprises one or more additional dies attached to the bottom side of the circuit board, wherein the one or more additional dies are also embedded in the solid support substance.

11. An electronic component according to claim 10, wherein the one or more dies comprise a MEMS die and the one or more additional dies comprises an ASIC die.

12. An electronic component according to claim 10, wherein the one or more dies comprise a MEMS die and the one or more additional dies comprises a microcontroller unit die.
